# EUROPEAN PATENT APPLICATION

(11) **EP 4 629 797 A2**
(43) Date of publication of application: **08.10.2025**
(21) Application number: 25168139.1
(22) Date of filing: 02.04.2025
(51) Int. Cl.: H10K 59/121, H10K 59/80

(54) **ELECTRONIC DEVICE AND METHOD OF MANUFACTURING DISPLAY DEVICE**

(30) Priority: 05.04.2024 KR 20240046908
(71) Applicant: Samsung Display Co., Ltd., Gyeonggi-Do (KR)
(72) Inventor: CHOI, Nakcho, Yongin-si (KR); CHUNG, Jinkoo, Yongin-si (KR)
(74) Representative: Marks & Clerk LLP

(57) **Abstract**

A display device includes a display panel including a circuit layer and a light emitting element layer and an optical path control layer disposed on the display panel to control an optical path of a light from the display panel. The optical path control layer in a first display area includes horizontal barrier walls arranged in a first direction and each extending in a second direction, the optical path control layer in the second display area includes vertical barrier walls arranged in the second direction and each extending in the first direction, and a transmissive portion is disposed between the horizontal barrier walls and between the vertical barrier walls. The second direction is substantially parallel to a direction toward the second display area from the first display area in a plan view, and the first direction is perpendicular to the second direction in the plan view.

## Description

### BACKGROUND

### 1. Field

Embodiments of the disclosure relate to a display device and a method of manufacturing the display device. More particularly, the disclosure relates to a display device including an optical path control layer and a method of manufacturing the display device.

### 2. Description of Related Art

Display devices used in various devices, such as televisions, mobile phones, tablets, vehicles, etc., are being developed. The limitation of a viewing angle of the display device may be desired in accordance with a user environment where information is desired to be protected or for safety regulations. Accordingly, researches are being carried out to limit the viewing angle.

### SUMMARY

Embodiments of the disclosure provide a display device in which a direction of a limited viewing angle and a degree of the limited viewing angle differ depending on its area, and an electronic device including the display device.

Embodiments of the disclosure provide a method of manufacturing the display device, which is capable of simultaneously forming two areas in which the direction of the limited viewing angle and the degree of the limited viewing angle differ depending on its area.

Embodiments of the invention provide a display device including a display area including a first display area and a second display area adjacent to the first display area and a non-display area surrounding the display area. In such embodiments, the display device includes a display panel including a circuit layer including a pixel driving circuit and a light emitting element layer disposed on the circuit layer, where the display panel includes a light emitting area and a non-light-emitting area surrounding the light emitting area, and an optical path control layer disposed on the display panel to control an optical path of a light provided thereto from the display panel. In such embodiments, the optical path control layer in the first display area includes a plurality of horizontal barrier walls arranged in a first direction and each extending in a second direction, the optical path control layer in the second display area includes a plurality of vertical barrier walls arranged in the second direction and each extending in the first direction, and a transmissive portion is disposed between the horizontal barrier walls and between the vertical barrier walls. In such embodiments, the first direction is perpendicular to a plane defined by a direction toward the second display area from the first display area and a direction toward the optical path control layer from the display panel, and the second direction is substantially parallel to the direction toward the second display area from the first display area.

In an embodiment, each of the horizontal barrier walls and each of the vertical barrier walls may include a light blocking material or a light absorbing material.

In an embodiment, the light emitting element layer may include a first-type light-emitting element electrically connected to the pixel driving circuit and a second-type light-emitting element electrically connected to the pixel driving circuit and disposed spaced apart from the first-type light-emitting element in the second direction.

In an embodiment, a color of a light emitted from the first-type light-emitting element may be substantially the same as a color of a light emitted from the second-type light-emitting element.

In an embodiment, each of the first-type light-emitting element and each of the second-type light-emitting element may overlap the horizontal barrier walls in a plan view.

In an embodiment, the first-type light-emitting element may overlap the vertical barrier walls in a plan view, and the second-type light-emitting element may not overlap the vertical barrier walls in the plan view.

In an embodiment, the light emitting element layer may include a pixel definition layer which defines the light emitting area, and the vertical barrier walls may include a plurality of first vertical barrier walls overlapping the pixel definition layer in a plan view, and a plurality of second vertical barrier walls overlapping the first-type light-emitting element in the plan view.

In an embodiment, the pixel driving circuit may selectively operate in one of a first mode and a second mode, the first-type light-emitting element may not emit a light in the first mode, the second-type light-emitting element emits a light in the first mode, the first-type light-emitting element may emit the light in the second mode, and the second-type light-emitting element may not emit the light in the second mode.

In an embodiment, the first-type light-emitting element may include a first first-type light-emitting element which emits a first color light, a second first-type light-emitting element which emits a second color light different from the first color light, and a third first-type light-emitting element which emits a third color light different from each of the first and second color lights, the second first-type light-emitting element may be disposed spaced apart from the first first-type light-emitting element in the first direction, and the third first-type light-emitting element may be disposed spaced apart from the first first-type light-emitting element in the second direction.

In an embodiment, the second-type light-emitting element may include a first second-type light-emitting element which emits a light having substantially a same color as the first first-type light-emitting element, a second second-type light-emitting element which emits a light having substantially a same color as the second first-type light-emitting element, and a third second-type light-emitting element which emits a light having substantially a same color as the third first-type light-emitting element, the first second-type light-emitting element may be disposed spaced apart from the first first-type light-emitting element in the second direction, the second second-type light-emitting element may be disposed spaced apart from the second first-type light-emitting element in the second direction, and the third second-type light-emitting element may be disposed spaced apart from the third first-type light-emitting element in the second direction.

Embodiments of the invention provide a display device including a display area including a first display area and a second display area adjacent to the first display area and a non-display area surrounding the display area. In such embodiments, the display device includes a display panel including a circuit layer including a pixel driving circuit and a light emitting element layer including a light emitting element and disposed on the circuit layer and an optical path control layer disposed on the display panel to control an optical path of a light provided thereto from the display panel. In such embodiments, the optical path control layer includes a first optical path control layer disposed in the first display area and a second optical path control layer disposed in the second display area. In such embodiments, the first optical path control layer includes a plurality of first barrier walls having a first height and a first transmissive portion disposed between the first barrier walls, and the second optical path control layer includes a plurality of second barrier walls having a second height smaller than the first height and a second transmissive portion disposed between the second barrier walls.

In an embodiment, the first height may be equal to or greater than about 35 micrometers and equal to or smaller than about 45 micrometers, and the second height is equal to or greater than about 20 micrometers and equal to or smaller than about 30 micrometers.

In an embodiment, each of the first barrier walls and each of the second barrier walls may include a light blocking material or a light absorbing material.

In an embodiment, the first transmissive portion may include a first-first transmissive portion disposed on the display panel and a first-second transmissive portion disposed on the first-first transmissive portion, and the second transmissive portion may include a same material as the first-second transmissive portion.

In an embodiment, the second optical path control layer may further include an organic layer disposed on the display panel and an inorganic layer disposed on the organic layer, and the organic layer may include a same material as the first-first transmissive portion.

In an embodiment, the first barrier walls may be arranged in a first direction and each of the first barrier walls may extend in a second direction, and the second barrier walls may be arranged in the second direction and each of the second barrier walls may extend in the first direction. In such an embodiment, the first direction is perpendicular to a plane defined by a direction toward the second display area from the first display area and a direction toward the optical path control layer from the display panel, and the second direction is substantially parallel to the direction toward the second display area from the first display area.

Embodiments of the invention provide a method of manufacturing a display device. In such embodiment, the method includes preparing a display panel including a display area including a first display area and a second display area adjacent to the first display area and a non-display area surrounding the display area, forming an organic pattern layer on the display panel, forming a transparent layer on the display panel through an inkjet coating process, and forming a light blocking pattern on the transparent layer and the organic pattern layer. In such embodiment, the forming the transparent layer includes forming a first transparent layer on the display panel in the first display area and forming a second transparent layer on the display panel in the second display area. In such embodiment, the forming the light blocking pattern includes forming a horizontal light blocking pattern arranged in a first direction and each extending in a second direction in the first display area, and forming a vertical light blocking pattern arranged in the second direction and each extending in the first direction in the second display area. In such embodiments, the first direction is perpendicular to a plane defined by a direction toward the second display area from the first display area and a direction toward the transparent layer from the display panel, and the second direction is substantially parallel to the direction toward the second display area from the first display area in the first display area.

In an embodiment, the forming the light blocking pattern may include forming a horizontal pattern arranged in the first direction and each extending in the second direction and a vertical pattern arranged in the second direction and each extending in the first direction in the transparent layer and the organic pattern layer through a photoresist process and providing a light absorbing material in the horizontal pattern and the vertical pattern to form a plurality of barrier walls.

In an embodiment, the display panel may include a first-type light-emitting element and a second-type light-emitting element disposed spaced apart from the first-type light-emitting element in the second direction, in the forming of the light blocking pattern, the horizontal light blocking pattern may be formed to overlap each of the first-type light-emitting element and each of the second-type light-emitting element in a plan view, and the vertical light blocking pattern may be formed to overlap the first-type light-emitting-element and not to overlap the second-type light-emitting element in the plan view.

In an embodiment, the forming the organic pattern layer may include forming an organic layer on the display panel and patterning the organic layer through a photoresist process to form a dam in a way such that the organic layer may remain in the first display area, the organic layer may be removed in the second display area, and the organic layer may remain in a portion of the non-display area.

In embodiments, a vehicle includes the display device described above.

At least some of the above and other features of the invention are set out in the claims.

According to embodiments of the invention, in one display device, the viewing angle in one area is limited in a vertical direction (up and down directions) and the viewing angle in the other area is selectively limited in a horizontal direction (left and right directions).

According to embodiments of the invention, two areas with different viewing angle limited directions and different degrees of the limited viewing angle are substantially simultaneously formed using a method of manufacturing the display device.

### BRIEF DESCRIPTION OF THE DRAWINGS

The above and other features of embodiments of the disclosure will become readily apparent by reference to the following detailed description when considered in conjunction with the accompanying drawings, in which:
FIG. 1 is a view illustrating an interior of an automobile to which a display device according to an embodiment of the disclosure is applied;
FIG. 2A is a view illustrating an image viewed from a driver's seat when a display device according to an embodiment of the disclosure operates in a first mode;
FIG. 2B is a view illustrating an image viewed from a driver's seat when a display device according to an embodiment of the disclosure operates in a second mode;
FIG. 2C is a view schematically illustrating a viewing angle of an image of a display device according to an embodiment of the disclosure;
FIGS. 3A and 3B are cross-sectional views illustrating display devices according to embodiments of the disclosure;
FIG. 4 is a block diagram illustrating a display device according to an embodiment of the disclosure;
FIG. 5 is an enlarged plan view illustrating a first display area according to an embodiment of the disclosure;
FIG. 6 is a cross-sectional view illustrating a portion of a first display area according to an embodiment of the disclosure;
FIG. 7 is an enlarged plan view illustrating a second display area according to an embodiment of the disclosure;
FIGS. 8A and 8B are cross-sectional views illustrating a portion of a second display area according to an embodiment of the disclosure;
FIGS. 9A to 11B are cross-sectional views illustrating a method of manufacturing a display device according to an embodiment of the disclosure; and
FIG. 12 is a plan view illustrating a display area according to an embodiment of the disclosure.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items.

It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

In the disclosure, it will be understood that when an element (or area, layer, or portion) is referred to as being "on", "connected to" or "coupled to" another element or layer, it can be directly on, connected or coupled to the other element or layer or intervening elements or layers may be present therebetween. In contrast, when an element is referred to as being "directly on" another element, there are no intervening elements present.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the disclosure will be described with reference to accompanying drawings.

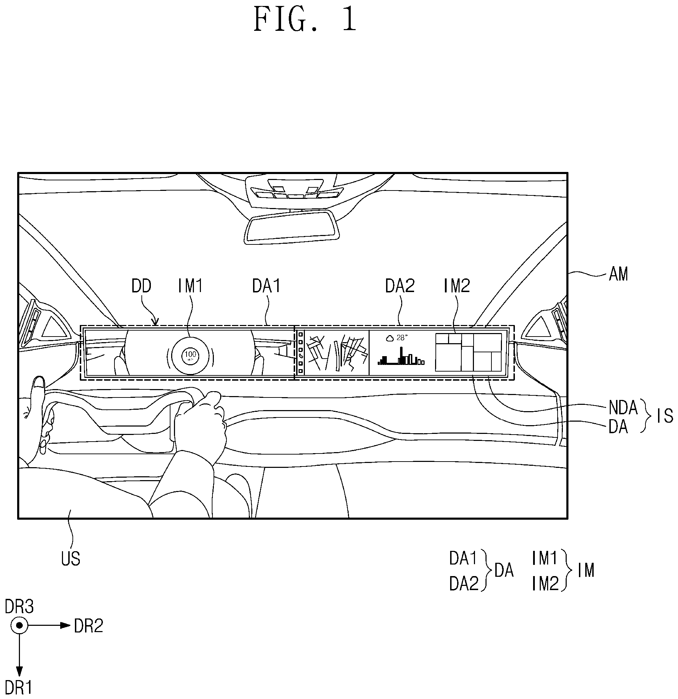

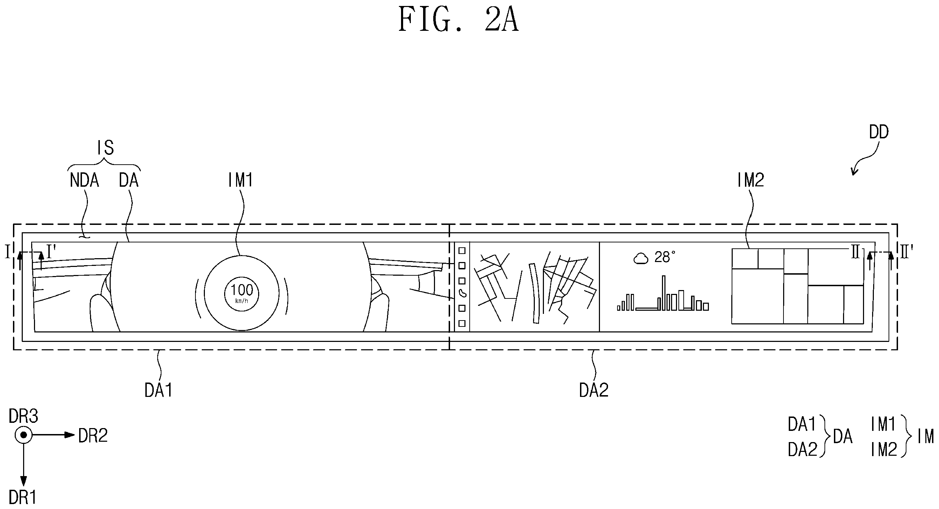

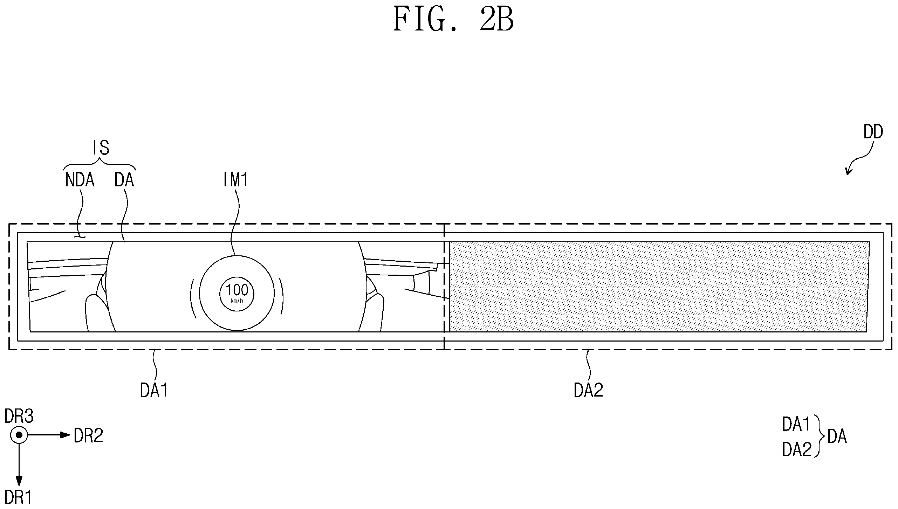

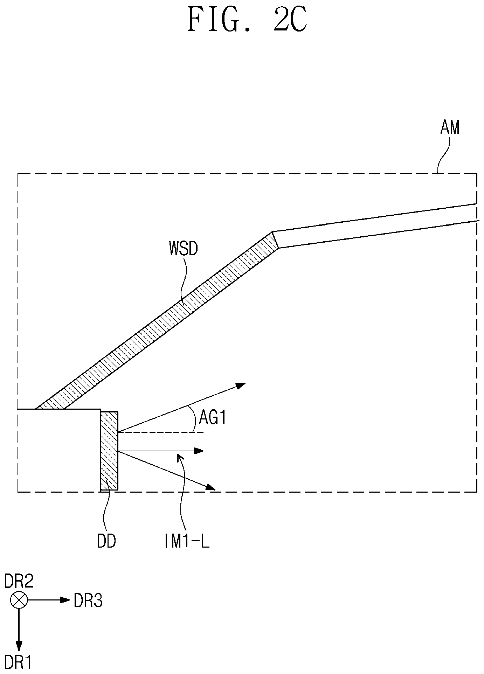

FIG. 1 is a view illustrating an interior of an automobile AM to which a display device DD according to an embodiment of the disclosure is applied. FIG. 2A is a view illustrating images IM1 and IM2 viewed from a driver's seat when the display device DD according to an embodiment of the disclosure operates in a first mode. FIG. 2B is a view illustrating the image IM1 viewed from the driver's seat when the display device DD according to an embodiment of the disclosure operates in a second mode. FIG. 2C is a view schematically illustrating a viewing angle AG1 of the image IM1 of the display device DD according to an embodiment of the disclosure.

Referring to FIG. 1, an embodiment of the display device DD may be disposed inside a vehicle, e.g., an automobile AM. The display device DD may be activated in response to electrical signals. In another embodiment, the display device DD may be applied to various electronic devices, such as a mobile phone, a tablet computer, a smart watch, a notebook computer, a computer, a smart television, etc. In an embodiment, as shown in FIG. 1, the display device DD may be placed inside the automobile AM to provide various information to a driver US.

In such an embodiment, the display device DD may display an image IM through a display surface IS substantially parallel to each of a first direction DR1 and a second direction DR2 crossing the first direction DR1. The display surface IS through which the image IM is displayed may correspond to a front surface of the display device DD. The image IM may include a still image as well as a video. A third direction DR3 may indicate a normal line direction of the display surface IS, i.e., a thickness direction of the display device DD. Hereinafter, front (or upper) and rear (or lower) surfaces of each layer or each unit of the display device DD may be distinguished from each other in the third direction DR3.

In the disclosure, the first direction DR1 may be referred to as an up-down direction, the second direction DR2 may be referred to as a left-right direction, and the third direction DR3 may be referred to as the thickness direction.

The display surface IS of the display device DD may include a display area DA and a non-display area NDA. The image IM may be displayed through the display area DA. A user may view the image IM through the display area DA. In an embodiment, for example, the display area DA may have a rectangular shape. However, this is merely an example, and the shape of the display area DA may be variously modified.

The non-display area NDA may be adjacent to the display area DA. The non-display area NDA may have a predetermined color. In an embodiment, for example, the non-display area NDA may surround the display area DA. Accordingly, the display area DA may have a shape substantially determined by the non-display area NDA, however, this is merely an example. In another embodiment, the non-display area NDA may be disposed adjacent to only one side of the display area DA or may be omitted. In embodiments of the invention, the non-display area NDA of the display device DD should not be particularly limited to those described above.

In an embodiment, the display area DA includes a first display area DA1 and a second display area DA2. In an embodiment, the first display area DA1 and the second display area DA2 may be display areas of a single display panel of the display device DD. The first display area DA1 may be placed in a position facing the driver's seat and may provide the driver US with a first image IM1 necessary for driving while on the road. The second display area DA2 may be placed in a position facing a passenger's seat and may provide a second image IM2. In an embodiment, for example, the first image IM1 may include speed information, vehicle status information, and vehicle internal operation information, etc., and the second image IM2 may include various non-driving-related information as well as driving-related information such as navigation information.

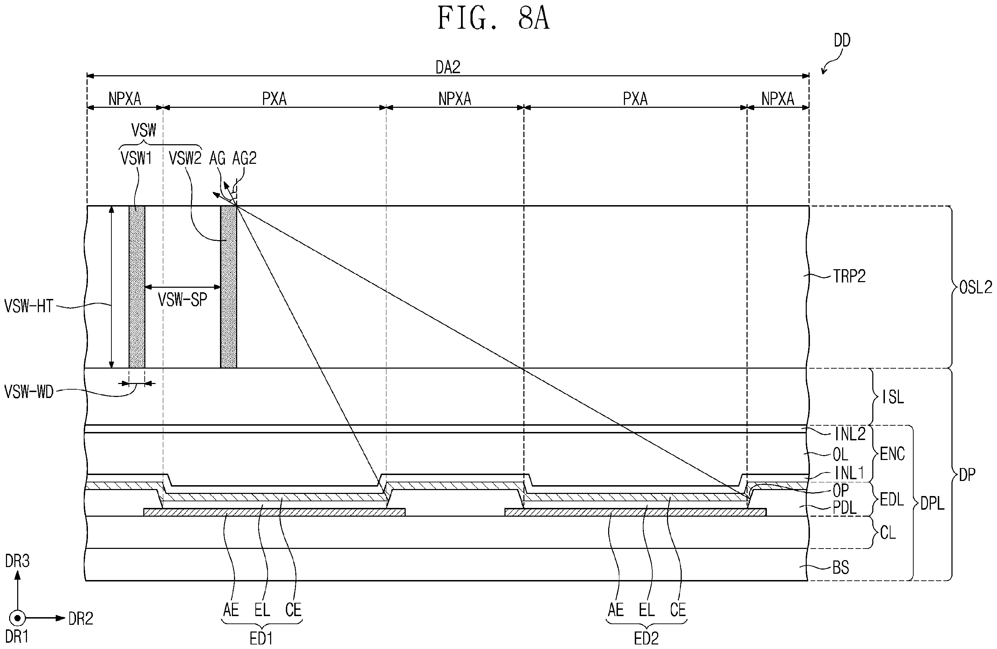

The display device DD may operate in the first mode or the second mode. In the first display area DA1, the viewing angle AG1 in the up-down direction DR1 may be limited in both the first mode and the second mode. In the second display area DA2, the first mode may be a normal mode where images are displayed at a first viewing angle AG (refer to FIG. 8A) in the left-right direction DR2, and the second mode may be a viewing angle control mode where images are displayed at a second viewing angle AG2 (refer to FIG. 8A) smaller than the first viewing angle AG (refer to FIG. 8A).

Referring to FIG. 2A, when the display device DD operates in the first mode, the driver US may view the first image IM1 displayed through the first display area DA1 and the second image IM2 displayed through the second display area DA2. The first mode may be activated while the automobile is stationary. The driver US may also view information not related to driving in the first mode.

Referring to FIG. 2B, when the display device DD operates in the second mode, the driver US may view the first image IM1 displayed through the first display area DA1 and may not view the second image IM2 in the second display area DA2. The second mode may be activated while the automobile is in motion. The driver US may view information related to driving only and may not view information not related to driving due to a viewing angle limitation. FIG. 2B illustrates the display device DD in a state in which the entire second display area DA2 is not visible to the driver US as a representative example, however, the disclosure should not be limited thereto or thereby. According to an embodiment, a portion of the second display area DA2 may be viewed, and the other portion of the second display area DA2 may not be viewed. In an embodiment, for example, the driver US may view information (e.g., navigation information) related to driving only, which is displayed through the portion of the second display area DA2 adjacent to the first display area DA1 and may not view information unnecessary for driving, which is displayed through the other portion of the second display area DA2 spaced apart from the first display area DA1. The portion of the second display area DA2, which is visible to the driver US, in the second mode may be adjusted by adjusting areas in which a first-type light-emitting element ED1 (refer to FIG. 8A) and a second-type light-emitting element ED2 (refer to FIG. 8A) described later are respectively operated.

In an embodiment, the display device DD may selectively operate in one of the first mode and the second mode. A switching operation between the first mode and the second mode may be set by the driver or may be performed when the automobile is stationary or in motion, or when a specific application is running.

Referring to FIG. 2C, the viewing angle AG1 in the up-down direction DR1 of the first display area DA1 (refer to FIG. 2A) may be limited in both the first mode and the second mode. That is, a light IM1-L provided through the first display area DA1 may not be viewed at an angle greater than the viewing angle AG1. A path of the light IM1-L provided through the first display area DA1 may be limited in the up-down direction DR1, and thus, the light IM1-L may not reach a windshield WSD of the automobile AM. Accordingly, a reflection light occurring when the light IM1-L provided through the first display area DA1 reaches the windshield WSD of the automobile AM may not be viewed to the driver US, and thus, a safety may be ensured.

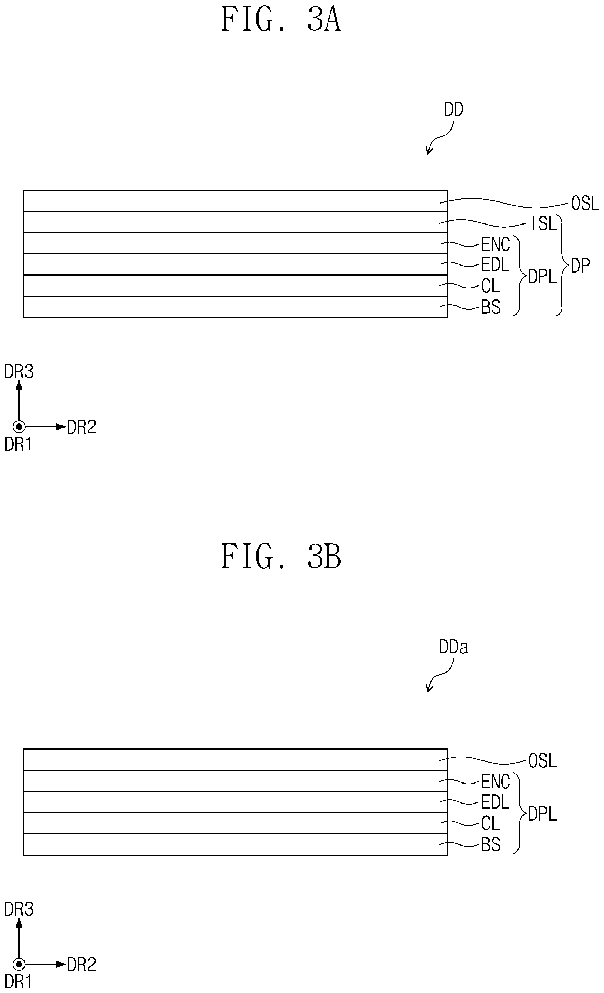

FIGS. 3A and 3B are cross-sectional views illustrating display devices DD and DDa according to embodiments of the disclosure.

Referring to FIG. 3A, an embodiment of the display device DD includes a display panel DP and an optical path control layer OSL. A protective film, a window, or a functional coating layer may be further disposed on the optical path control layer OSL to provide a front surface of the display device DD.

In an embodiment, the display panel DP may include a display layer DPL and a sensor layer ISL.

The display layer DPL may include a base layer BS, a circuit layer CL, a light emitting element layer EDL, and an encapsulation layer ENC. The display layer DPL may have a configuration that substantially generates the images. The display layer DPL may be a light emitting type display layer. In an embodiment, for example, the display layer DPL may be an organic light emitting display layer, an inorganic light emitting display layer, an organic-inorganic light emitting display layer, a quantum dot display layer, a micro-light emitting diode (LED) display layer, or a nano-LED display layer.

The sensor layer ISL may sense an external input applied thereto from the outside. In an embodiment, for example, the external input may be a user input. The user input may include a variety of forms of external inputs, such as a part of a user's body, light, heat, pen, or pressure. The sensor layer ISL may be referred to as a sensor, an input sensor layer, or an input sensing panel. In an embodiment, the sensor layer ISL may be formed on the display layer DPL through successive processes, however, it should not be limited thereto or thereby. In another embodiment, for example, the sensor layer ISL may be coupled with the display layer DPL by an adhesive layer.

The optical path control layer OSL may control a path of the light provided from the display layer DPL. The optical path control layer OSL may include a structure to control the path of the light. The optical path control layer OSL may be disposed on the sensor layer ISL. In an embodiment, the optical path control layer OSL may be formed together with the display layer DPL and the sensor layer ISL through successive processes and may be disposed directly on the sensor layer ISL, however, it should not be particularly limited. In an embodiment, for example, the optical path control layer OSL may be coupled with the sensor layer ISL by an adhesive layer.

Referring to FIG. 3B, an embodiment of the display device DDa includes a display layer DPL and an optical path control layer OSL. In such an embodiment, the display device DDa of FIG. 3B may not include a sensor layer (refer to ISL of FIG. 3A). In an embodiment, the optical path control layer OSL may be formed together with the display layer DPL through successive processes and may be disposed directly on the display layer DPL, however, it should not be particularly limited.

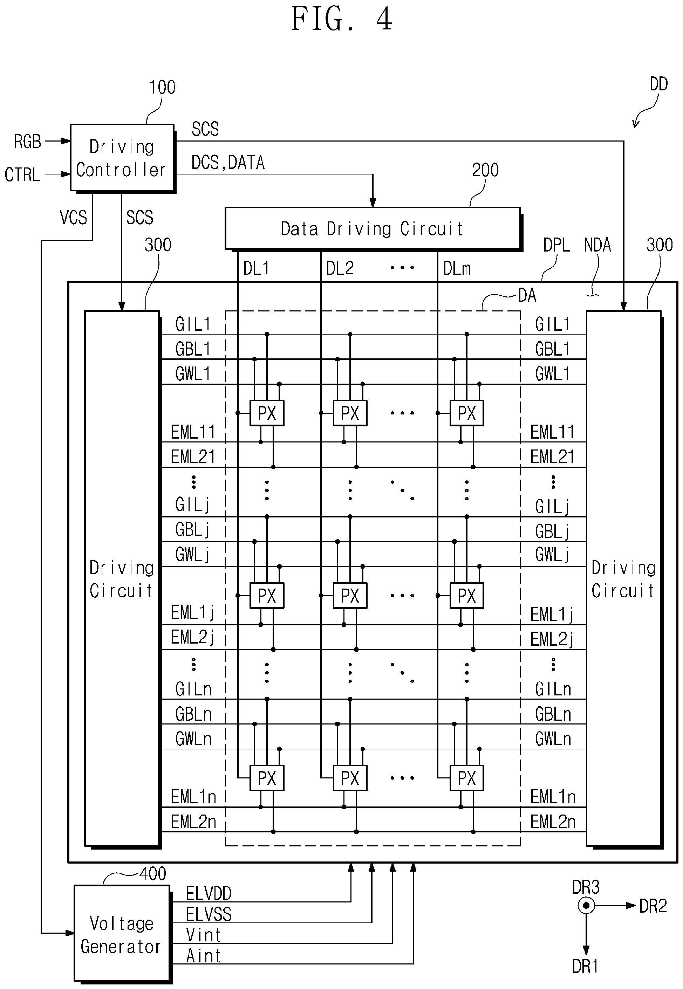

FIG. 4 is a block diagram illustrating the display device DD according to an embodiment of the disclosure.

Referring to FIG. 4, an embodiment of the display device DD may further include a driving controller 100 and a panel driver to drive the display layer DPL. In an embodiment, for example, the panel driver may include a data driving circuit (or a data driver) 200, a driving circuit 300, and a voltage generator 400.

The display layer DPL may include the display area DA and the non-display area NDA. The display layer DPL may include a plurality of pixels PX arranged in the display area DA. Each of the pixels PX may include at least one light emitting element and a pixel driving circuit controlling a light emission of the light emitting element. The pixel driving circuit may include one or more transistors and one or more capacitors.

The display layer DPL may further include initialization scan lines GIL1 to GILn, write scan lines GWL1 to GWLn, black scan lines GBL1 to GBLn, first light emission control lines EML11 to EML1n, second light emission control lines EML21 to EML2n, and data lines DL1 to DLm. According to an embodiment, the display layer DPL may further include third light emission control lines.

The driving controller 100 may receive image signals RGB and control signals CTRL. The driving controller 100 may convert a data format of the image signals RGB to a data format appropriate to an interface between the data driving circuit 200 and the driving controller 100 to generate image data signals DATA. The driving controller 100 may output a first control signal SCS, a second control signal DCS, and a third control signal VCS.

The data driving circuit 200 may receive the second control signal DCS and the image data signals DATA from the driving controller 100. The data driving circuit 200 may convert the image data signals DATA to data signals and may output the data signals to the data lines DL1 to DLm. The data signals may be analog voltages corresponding to grayscale values of the image data signals DATA. The data lines DL1 to DLm may be arranged in the second direction DR2, and each of the data lines DL1 to DLm may extend in the first direction DR1.

In an embodiment, the driving circuit 300 may be disposed in the non-display area NDA of the display layer DPL, however, it should not be particularly limited. In another embodiment, for example, at least a portion of the driving circuit 300 may be disposed in the display area DA. The driving circuit 300 may include transistors formed through the same process as the pixel driving circuit.

The driving circuit 300 may receive the first control signal SCS and may output a scan signal or a light emission control signal to the initialization scan lines GIL1 to GILn, the write scan lines GWL1 to GWLn, the black scan lines GBL1 to GBLn, the first light emission control lines EML11 to EML1n, and the second light emission control lines EML21 to EML2n.

The driving circuit 300 may be provided in plural. In an embodiment, for example, the driving circuits 300 may be spaced apart from each other with the display area DA interposed therebetween. The initialization scan lines GIL1 to GILn, the write scan lines GWL1 to GWLn, the black scan lines GBL1 to GBLn, the first light emission control lines EML11 to EML1n, and the second light emission control lines EML21 to EML2n may be electrically connected to the driving circuits 300 and may receive signals from the driving circuits 300. In an embodiment, for example, one initialization scan line GIL1, one write scan line GWL1, one black scan line GBL1, one first light emission control line EML11, and one second light emission control line EML21 may receive the same signals from two driving circuits 300. However, this is merely an example, and in another embodiment, one of the two driving circuits 300 shown in FIG. 4 may be omitted.

Each of the driving circuits 300 may include a scan driving circuit connected to the initialization scan lines GIL1 to GILn, the write scan lines GWL1 to GWLn, and the black scan lines GBL1 to GBLn and a light emission control driving circuit connected to the first light emission control lines EML11 to EML1n and the second light emission control lines EML21 to EML2n. The scan driving circuit and the light emission control driving circuit may be spaced apart from each other with the display area DA interposed therebetween.

The initialization scan lines GIL1 to GILn, the write scan lines GWL1 to GWLn, the black scan lines GBL1 to GBLn, the first light emission control lines EML11 to EML1n, and the second light emission control lines EML21 to EML2n may extend in the second direction DR2, and the initialization scan lines GIL1 to GILn, the write scan lines GWL1 to GWLn, the black scan lines GBL1 to GBLn, the first light emission control lines EML11 to EML1n, and the second light emission control lines EML21 to EML2n may be spaced apart from each other in the first direction DR1.

Each of the pixels PX may be electrically connected to three scan lines, two light emission control lines, and one data line. In an embodiment, for example, pixels arranged in a first row may be connected to the scan lines GIL1, GWL1, and GBL1 and the first and second light emission control lines EML11 and EML21 as shown in FIG. 4. Pixels arranged in a first column may be connected to the data line DL1. In addition, pixels arranged in a j-th row may be connected to the scan lines GILj, GWLj, and GBLj and the first and second light emission control lines EML1j and EML2j.

The voltage generator 400 may generate voltages required to operate the display panel DP. The voltage generator 400 may generate a first driving voltage ELVDD, a second driving voltage ELVSS, a first initialization voltage Vint, and a second initialization voltage Aint.

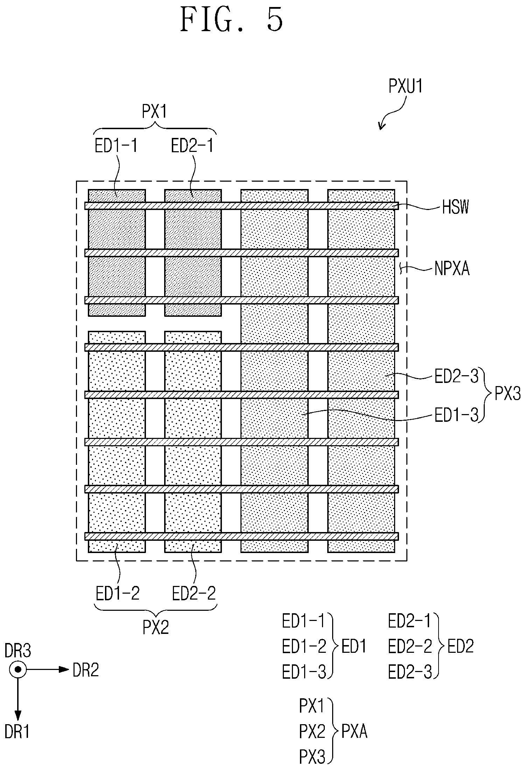

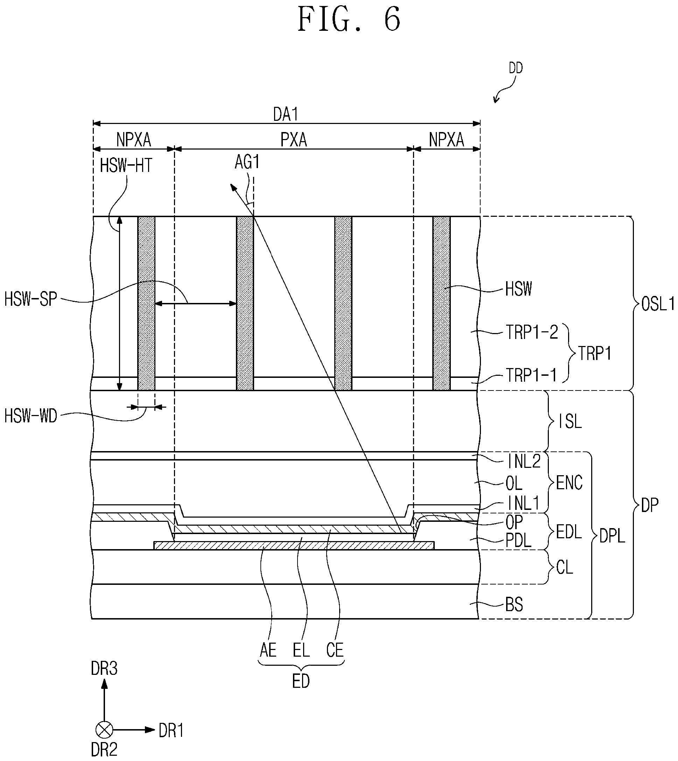

FIG. 5 is an enlarged plan view illustrating the first display area (refer to DA1 of FIG. 1) according to an embodiment of the disclosure, and FIG. 6 is a cross-sectional view illustrating a portion of the first display area DA1 according to an embodiment of the disclosure.

FIG. 5 is a plan view illustrating the light emitting elements ED1 and ED2 included in the display panel DP (refer to FIG. 3A) and a plurality of horizontal barrier walls HSW included in an optical path control layer OSL1 (refer to FIG. 6) in the first display area DA1 (refer to FIG. 1) in a plan view (or when viewed in the third direction DR3). Each of the horizontal barrier walls HSW may extend in the second direction DR2 and the horizontal barrier walls HSW may be arranged in the first direction DR1. The optical path control layer OSL1 in the first display area DA1 (refer to FIG. 1) may be referred to as a first optical path control layer.

Referring to FIG. 5, in an embodiment, a plurality of pixels PX1, PX2, and PX3 may be arranged in the first display area DA1 (refer to FIG. 1) of the display panel DP (refer to FIG. 3A). The pixels PX1, PX2, and PX3 may include a first color pixel PX1, a second color pixel PX2, and a third color pixel PX3. The first color pixel PX1 may emit a first color light, e.g., a red light. The second color pixel PX2 may emit a second color light, e.g., a green light. The third color pixel PX3 may emit a third color light, e.g., a blue light.

The second color pixel PX2 may be disposed spaced apart from the first color pixel PX1 in the first direction DR1. The third color pixel PX3 may be disposed spaced apart from the first color pixel PX1 and the second color pixel PX2 in the second direction DR2. However, the arrangement of the first, second, and third color pixels PX1, PX2, and PX3 should not be limited thereto or thereby.

FIG. 5 shows an embodiment in which one pixel unit PXU1 includes three pixels PX1, PX2, and PX3 as a representative example. In another embodiment, one pixel unit PXU1 may include two pixels or four or more pixels. In addition, FIG. 5 shows an embodiment in which the third color pixel PX3 has the largest size and the first color pixel PX1 has the smallest size, however, the disclosure should not be limited thereto or thereby, and the size of the first to third color pixels PX1 to PX3 may be variously modified. Further, FIG. 5 shows an embodiment in which each of the first, second, and third color pixels PX1, PX2, and PX3 has a rectangular shape in a plan view (or when viewed in the third direction DR3), however, the shape of the first, second, and third color pixels PX1, PX2, and PX3 should not be limited thereto or thereby.

The pixel unit PXU1 may include the first-type light-emitting element ED1 and the second-type light-emitting element ED2. The first-type light-emitting element ED1 and the second-type light-emitting element ED2 may be alternately arranged with each other in the second direction DR2. The first-type light-emitting element ED1 and the second-type light-emitting element ED2 may operate differently or independently of each other. In an embodiment of an example, both the first-type light-emitting element ED1 and the second-type light-emitting element ED2 may operate substantially simultaneously, or only one of the first-type light-emitting element ED1 and the second-type light-emitting element ED2 may operate. In an embodiment, for example, in the first mode, the first-type light-emitting element ED1 may not operate, and only the second-type light-emitting element ED2 may operate, and in the second mode, only the first-type light-emitting element ED1 may operate, and the second-type light-emitting element ED2 may not operate.

The first-type light-emitting element ED1 may include a first first-type light-emitting element ED1-1 disposed in the first color pixel PX1, a second first-type light-emitting element ED1-2 disposed in the second color pixel PX2, and a third first-type light-emitting element ED1-3 disposed in the third color pixel PX3. The second-type light-emitting element ED2 may include a first second-type light-emitting-element ED2-1 disposed in the first color pixel PX1, a second-type light-emitting-element ED2-2 disposed in the second color pixel PX2, and a third second-type light-emitting-element ED2-3 disposed in the third color pixel PX3.

The first second-type light-emitting element ED2-1 may be disposed spaced apart from the first first-type light-emitting element ED1-1 in the second direction DR2. The second second-type light-emitting element ED2-2 may be disposed spaced apart from the second first-type light-emitting element ED1-2 in the second direction DR2. The third second-type light-emitting element ED2-3 may be disposed spaced apart from the third first-type light-emitting element ED1-3 in the second direction DR2. The second first-type light-emitting element ED1-2 may be disposed spaced apart from the first first-type light-emitting element ED1-1 in the first direction DR1. The second second-type light-emitting element ED2-2 may be disposed spaced apart from the first second-type light-emitting element ED2-1 in the first direction DR1.

Referring to FIG. 6, an embodiment of the display device DD may include the display panel DP and the first optical path control layer OSL1 in the first display area DA1. The display panel DP may include the display layer DPL and the sensor layer ISL. In another embodiment, as described above, the sensor layer ISL may be omitted.

In an embodiment, the display layer DPL may include the base layer BS, the circuit layer CL, the light emitting element layer EDL, and the encapsulation layer ENC.

The base layer BS may provide a base surface on which the circuit layer CL is disposed. The base layer BS may include a synthetic resin layer. The synthetic resin layer may be a polyimide-based resin layer, however, it should not be limited thereto or thereby. The base layer BS may include a glass substrate, a metal substrate, or an organic/inorganic composite material substrate.

The display layer DPL may further include an inorganic layer (not shown) on an upper surface of the base layer BS. The inorganic layer may include at least one selected from aluminium oxide, titanium oxide, silicon oxide, silicon nitride, silicon oxynitride, zirconium oxide, and hafnium oxide. The inorganic layer may be formed in multiple layers. The inorganic layers may form or define a barrier layer and/or a buffer layer.

The circuit layer CL may be disposed on the base layer BS. A semiconductor pattern may be disposed on the circuit layer CL. In an embodiment, the semiconductor pattern may include polysilicon, however, it should not be limited thereto or thereby. In another embodiment, the semiconductor pattern may include amorphous silicon, low temperature polycrystalline silicon, or oxide semiconductor. The circuit layer CL may further include a plurality of insulating layers. The insulating layers may cover the semiconductor pattern. Some of the insulating layers may be an inorganic layer, and the other of the insulating layers may be an organic layer. In an embodiment, the inorganic layer may include at least one selected from aluminium oxide, titanium oxide, silicon oxide, silicon nitride, silicon oxynitride, zirconium oxide, and hafnium oxide.

The light emitting element layer EDL may be disposed on the circuit layer CL. The light emitting element layer EDL may include the light emitting element ED. The light emitting element layer EDL may include an organic light emitting material, an inorganic light emitting material, an organic-inorganic light emitting material, a quantum dot, a quantum rod, a micro-LED, or a nano-LED. Hereinafter, an organic light emitting element will be described as the light emitting elements ED, however, it should not be particularly limited.

The light emitting element ED of FIG. 6 may correspond to the light emitting element ED1 or ED2 of FIG. 5.

The light emitting element ED may include a first electrode AE, a light emitting layer EL, and a second electrode CE.

The first electrode AE may be disposed on the circuit layer CL. The first electrode AE may be electrically connected to the semiconductor pattern of the circuit layer CL. The first electrode AE may have a conductivity. The first electrode AE may include or be formed of a metal material, a metal alloy, or a conductive compound. The first electrode AE may be an anode or a cathode. In addition, the first electrode AE may be a pixel electrode. The first electrode AE may be a transmissive electrode, a transflective electrode, or a reflective electrode. The first electrode AE may include at least one selected from Ag, Mg, Cu, Al, Pt, Pd, Au, Ni, Nd, Ir, Cr, Li, Ca, LiF, Mo, Ti, W, In, Sn, and Zn, compounds of two or more thereof, mixtures of two or more thereof, or an oxide thereof.

In an embodiment where the first electrode AE is the transmissive electrode, the first electrode AE may include a transparent metal oxide, e.g., indium tin oxide (ITO), indium zinc oxide (IZO), zinc oxide (ZnO), indium tin zinc oxide (ITZO), or the like. In an embodiment where the first electrode AE is the transflective or reflective electrode, the first electrode AE may include at least one selected from Ag, Mg, Cu, Al, Pt, Pd, Au, Ni, Nd, Ir, Cr, Li, Ca, LiF/Ca (a stack structure of LiF and Ca), LiF/Al (a stack structure of LiF and Al), Mo, Ti, W, a compound thereof, or a mixture thereof, e.g., a mixture of Ag and Mg. The first electrode AE may have a multi-layer structure of a reflective or transflective layer including or formed of at least one selected from the above materials and a transparent conductive layer including or formed of indium tin oxide (ITO), indium zinc oxide (IZO), zinc oxide (ZnO), indium tin zinc oxide (ITZO), or the like. In an embodiment, for example, the first electrode AE may have a three-layer structure of ITO/Ag/ITO, however, it should not be limited thereto or thereby. According to an embodiment, the first electrode AE may include at least one of the above metal materials, a combination of two or more thereof, or an oxide thereof.

The light emitting element layer EDL may include a pixel definition layer PDL. The pixel definition layer PDL may be disposed on the circuit layer CL and may cover a portion of the first electrode AE. The pixel definition layer PDL may be provided with an opening OP defined therethrough. At least a portion of the first electrode AE may be exposed through the opening OP of the pixel definition layer PDL.

The display area DA (refer to FIG. 1) may include a light emitting area PXA and a non-light-emitting area NPXA adjacent to the light emitting area PXA. The non-light-emitting area NPXA may surround the light emitting area PXA. In an embodiment, the light emitting area PXA may be defined to correspond to the portion of the first electrode AE exposed through the opening OP.

The light emitting layer EL may be disposed on the first electrode AE. The light emitting layer EL may be disposed in an area corresponding to the opening OP. That is, the light emitting layer EL may be formed in each of the pixels after being divided into plural portions. In an embodiment where the light emitting layer EL is formed in each of the pixels after being divided into plural portions, each of the light emitting layers EL may emit a light having at least one selected from red, green, and blue colors, however, it should not be limited thereto or thereby. In another embodiment, the light emitting layer EL may be integrally formed and may be commonly provided to the pixels. In such an embodiment, the light emitting layer EL may provide a blue light or a white light.

The second electrode CE may be disposed on the light emitting layer EL. The second electrode CE may have an integral shape and may be commonly disposed over the pixels. The second electrode CE may be a cathode or an anode. For example, when the first electrode AE is the anode, the second electrode CE may be the cathode, and when the first electrode AE is the cathode, the second electrode CE may be the anode. The second electrode CE may include a same materials as the first electrode AE described above.

Although not shown in figures, a hole control layer may be disposed between the first electrode AE and the light emitting layer EL. The hole control layer may be commonly disposed in the light emitting area PXA and the non-light-emitting area NPXA. The hole control layer may include a hole transport layer and may further include a hole injection layer. An electron control layer may be disposed between the light emitting layer EL and the second electrode CE. The electron control layer may include an electron transport layer and may further include an electron injection layer. Each of the hole control layer and the electron control layer may be commonly formed in the plural pixels using an open mask.

The encapsulation layer ENC may be disposed on the light emitting element layer EDL. The encapsulation layer ENC may include an inorganic layer INL1, an organic layer OL, and an inorganic layer INL2, which are sequentially stacked one on another, however, the layers of the encapsulation layer ENC should not be limited thereto or thereby.

The inorganic layers INL1 and INL2 may protect the light emitting element layer EDL from moisture and oxygen, and the organic layer OL may protect the light emitting element layer EDL from a foreign substance such as dust particles. The inorganic layers INL1 and INL2 may include a silicon nitride layer, a silicon oxynitride layer, a silicon oxide layer, a titanium oxide layer, or an aluminium oxide layer. The organic layer OL may include an acrylic-based organic material, however, it should not be limited thereto or thereby.

The sensor layer ISL may include at least one conductive layer and at least one insulating layer.

The conductive layer may have a single-layer or multi-layer structure. The conductive layer having the single-layer structure may include a metal layer or a transparent conductive layer. The metal layer may include molybdenum, silver, titanium, copper, aluminium, or alloys thereof. The transparent conductive layer may include a transparent conductive oxide, such as indium tin oxide (ITO), indium zinc oxide (IZO), zinc oxide (ZnO), indium zinc tin oxide (ITZO), or the like. In addition, the transparent conductive layer may include conductive polymer such as poly(3,4-ethylenedioxythiophene) (PEDOT), metal nanowire, graphene, or the like. The conductive layer having the multi-layer structure may include metal layers. The metal layers may have a three-layer structure of titanium/aluminium/titanium. The conductive layer having the multi-layer structure may include at least one metal layer and at least one transparent conductive layer.

The insulating layer may include an inorganic layer. The inorganic layer may include at least one selected from aluminium oxide, titanium oxide, silicon oxide, silicon nitride, silicon oxynitride, zirconium oxide, and hafnium oxide. The insulating layer may include an organic layer. The organic layer may include at least one selected from an acrylic-based resin, a methacrylic-based resin, a polyisoprene-based resin, a vinyl-based resin, an epoxy-based resin, a urethane-based resin, a cellulose-based resin, a siloxane-based resin, a polyimide-based resin, a polyamide-based resin, and a perylene-based resin.

The first optical path control layer OSL1 may include the horizontal barrier walls HSW and a first transmissive portion TRP1 disposed between the horizontal barrier walls HSW. The first optical path control layer OSL1 may be disposed on the display panel DP in the first display area DA1.

In the first display area DA1, the first-type light-emitting element ED1 and the second-type light-emitting element ED2 may overlap the horizontal barrier walls HSW in the plan view or in the third direction DR3. The first-type light-emitting element ED1 and the second-type light-emitting element ED2 of FIG. 5 may correspond to the light emitting element ED of FIG. 6. As the light emitting element ED overlaps the horizontal barrier walls HSW, the viewing angle AG1 of a light emitted from the light emitting element ED may be limited in the first direction DR1 as shown in FIG. 6. That is, the image IM1 (refer to FIG. 1) in the first display area DA1 may not be visible at an angle exceeding the viewing angle AG1 in the first direction DR1 based on the third direction DR3 (0°). Accordingly, as described with FIG. 2C, the light IM1-L (refer to FIG. 2C) emitted from the first display area DA1 (refer to FIG. 1) may be effectively prevented from being reflected by the windshield WSD (refer to FIG. 2C) of the automobile AM (refer to FIG. 2C) and may be effectively prevented from being perceived by the driver US (refer to FIG. 2C).

The horizontal barrier walls HSW may include a light absorbing material or a light blocking material. The light incident into the horizontal barrier walls HSW may not be reflected and may be absorbed by the horizontal barrier walls HSW.

The horizontal barrier walls HSW may have a height (a length in the third direction DR3) HSW-HT and a distance (an interval or a gap) HSW-SP, which are changed depending on a resolution, e.g., pixel per inch (PPI), of the pixel or the viewing angle AG1. In an embodiment, the height HSW-HT of the horizontal barrier wall HSW may be equal to or greater than about 35 micrometers (µm) and equal to or smaller than about 45 µm. In an embodiment, the distance HSW-SP of the horizontal barrier wall HSW may be equal to or greater than about 8 µm and equal to or smaller than about 12 µm. In an embodiment, a width HSW-WD of the horizontal barrier walls HSW may be equal to or greater than about 3 µm and equal to or smaller than about 5 µm. In such an embodiment where the horizontal barrier walls HSW have the height, distance, and width respectively within the ranges described above, the viewing angle AG1 of the first display area DA1 (refer to FIG. 1) in the first direction DR1 may be about 35°.

The first transmissive portion TRP1 may be disposed between the horizontal barrier walls HSW. The first transmissive portion TRP1 may be a transmissive portion disposed in the first display area DA1. The first transmissive portion TRP1 may include a first first transmissive portion TRP1-1 disposed on the display panel DP and a first second transmissive portion TRP1-2 disposed on the first first transmissive portion TRP1-1. The first first transmissive portion TRP1-1 and the first second transmissive portion TRP1-2 may be formed through different processes or may be formed in a single process with a time interval. The first first transmissive portion TRP1-1 may be disposed in the first display area DA1 to cause a difference between the height HSW-HT of the horizontal barrier walls HSW of the first display area DA1 and a height VSW-HT of a plurality of vertical barrier walls VSW of the second display area DA2 (refer to FIG. 8A) described later. In an embodiment, the height HSW-HT of the horizontal barrier wall HSW may be greater than the height VSW-HT of the vertical barrier walls VSW.

The first transmissive portion TRP1 may include a transparent organic material. Each of the first first transmissive portion TRP1-1 and the first second transmissive portion TRP1-2 may include the transparent organic material. The light provided from the display panel DP may transmit through the first first transmissive portion TRP1-1 and the first second transmissive portion TRP1-2.

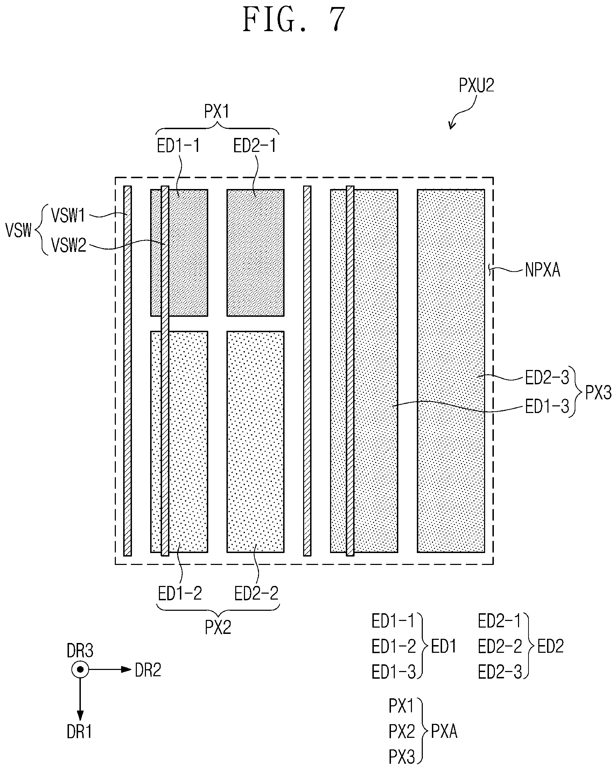

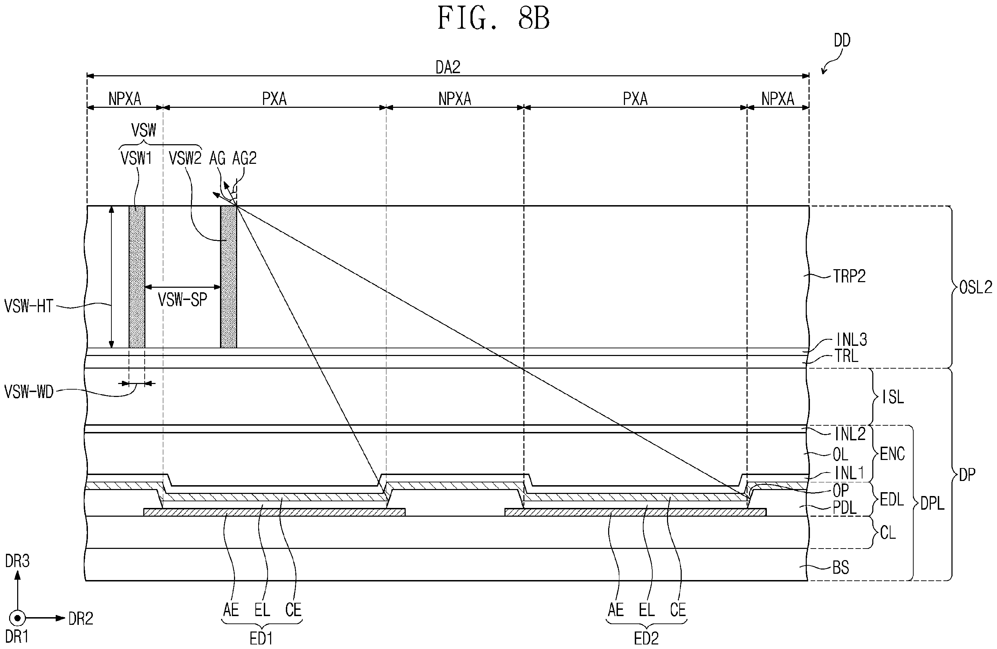

FIG. 7 is an enlarged plan view illustrating the second display area DA2 (refer to FIG. 1) according to an embodiment of the disclosure. FIGS. 8A and 8B are cross-sectional views illustrating a portion of the second display area DA2 according to an embodiment of the disclosure.

FIG. 7 is a plan view illustrating the light emitting elements ED1 and ED2 included in the display panel DP (refer to FIG. 3A) and the vertical barrier walls VSW included in an optical path control layer OSL2 (refer to FIG. 8A) in the second display area DA2 (refer to FIG. 1) when viewed in the third direction DR3. The optical path control layer OSL2 of the second display area DA2 (refer to FIG. 1) may be referred to as a second optical path control layer.

A pixel unit PXU2 in the second display area DA2 may include first, second, and third color pixels PX1, PX2, and PX3. The features of the first, second, and third color pixels PX1, PX2, and PX3 of the pixel unit PXU1 in the first display area DA1 (refer to FIG. 5) described above with reference to FIG. 5 may be applied to the first, second, and third color pixels PX1, PX2, and PX3 of the pixel unit PXU2 in the second display area DA2.

The pixel unit PXU2 may include the first-type light-emitting element ED1 and the second-type light-emitting element ED2, and the features of the first-type light-emitting element ED1 and the second-type light-emitting element ED2 described above with reference to FIG. 5 may be applied to the first-type light-emitting element ED1 and the second-type light-emitting element ED2 of the pixel unit PXU2.

The display device DD may include the display panel DP and the second optical path control layer OSL2 in the second display area DA2. The features of the display panel DP described above with reference to FIG. 6 may be applied to the display panel DP of FIGS. 8A and 8B.

Referring to FIGS. 7 and 8A, the second optical path control layer OSL2 may include the vertical barrier walls VSW and a second transmissive portion TRP2 disposed between the vertical barrier walls VSW. The second optical path control layer OSL2 may be disposed on the display panel DP in the second display area DA2. Each of the vertical barrier walls VSW may extend in the first direction DR1 and the vertical barrier walls VSW may be arranged in the second direction DR2.

In the second display area DA2, the first-type light-emitting element ED1 may overlap the vertical barrier walls VSW in the plan view or in the third direction DR3, and the second-type light-emitting element ED2 may not overlap the vertical barrier walls VSW in the plan view or in the third direction DR3.

The vertical barrier walls VSW may include first vertical barrier walls VSW1 overlapping the pixel definition layer PDL in the third direction DR3 and second vertical barrier walls VSW2 overlapping the first-type light-emitting element ED1 in the third direction DR3.

When viewed from the driver's seat, a viewing angle AG2 of the first-type light-emitting element ED1 in the second direction DR2 may be smaller than a viewing angle AG of the second-type light-emitting element ED2 in the second direction DR2. Since the vertical barrier walls VSW are not disposed on the second-type light-emitting element ED2, a light emitted from the second-type light-emitting element ED2 may have the first viewing angle AG.

Since the first vertical barrier walls VSW1 may be disposed on the pixel definition layer PDL adjacent to the first display area DA1 in the pixel definition layer PDL adjacent to the first-type light-emitting element ED1 and the second vertical barrier walls VSW2 are disposed on the first-type light-emitting element ED1, a light emitted from the first-type light-emitting element ED1 may have the second viewing angle AG2 smaller than the first viewing angle AG.

When the display device DD operates in the first mode, the second-type light-emitting element ED2 may operate, and thus, the viewing angle AG in the second direction DR2 may be wide. Accordingly, as shown in FIG. 2A, the image IM2 (refer to FIG. 2A) of the second display area DA2 may be perceived from the driver's seat. When the display device DD operates in the first mode, the first-type light-emitting element ED1 may operate or may not operate.

When the display device DD operates in the second mode, the second-type light-emitting element ED2 may not operate and only the first-type light-emitting element ED1 may operate. Thus, the viewing angle AG2 in the second direction DR2 may be narrow. Accordingly, as shown in FIG. 2B, the image IM2 (refer to FIG. 2B) of the second display area DA2 may not be perceived from the driver's seat.

FIGS. 7 and 8B show an embodiment in which the first vertical barrier walls VSW1 are disposed in a direction opposite to the second direction DR2 with respect to the first-type light-emitting element ED1 in the plan view or when viewed in the third direction DR3. In such an embodiment, the viewing angle AG2 of the first-type light-emitting element ED1 in the direction opposite to the second direction DR2 may be limited, and when only the first-type light-emitting element ED1 operates as shown in FIG. 1, the image IM2 of the second display area DA2 may not be perceived by the driver US (refer to FIG. 1).

However, the arrangement of the first vertical barrier walls VSW1 in the plan view should not be limited thereto or thereby. In another embodiment, for example, when the driver's seat is located on the right side different from the driver's seat of FIG. 1, the first vertical barrier walls VSW1 may be arranged in the second direction DR2 with respect to the first-type light-emitting element ED1.

In FIGS. 7 to 8B, the expression that the viewing angle in the second direction DR2 is limited may mean that the viewing angle in the direction opposite to the second direction DR2 is limited.

The vertical barrier walls VSW may include a light absorbing or blocking material. The light incident into the vertical barrier walls VSW may not be reflected and may be absorbed by the vertical barrier walls VSW. The vertical barrier walls VSW may include a same material as that of the horizontal barrier walls HSW (refer to FIG. 5) and may be formed through a same process as the horizontal barrier walls HSW (refer to FIG. 5).

The vertical barrier walls VSW may have a height VSW-HT and a distance VSW-SP, which are changed depending on a resolution (e.g., PPI) of the pixel or the viewing angle AG2 of the first-type light-emitting element ED1. In an embodiment, the distance VSW-SP may indicate a narrow distance between the first vertical barrier walls VSW1 and the second vertical barrier walls VSW2. In an embodiment, the height VSW-HT of the vertical barrier walls VSW may be equal to or greater than about 20 µm and equal to or smaller than about 30 µm. In an embodiment, the distance VSW-SP of the vertical barrier walls VSW may be equal to or greater than about 8 µm and equal to or smaller than about 15 µm. In an embodiment, a width VSW-WD of the vertical barrier walls VSW may be equal to or greater than about 3 µm and equal to or smaller than about 5 µm. In such an embodiment where the vertical barrier walls VSW have the height, distance, and width respectively within the ranges described above, the viewing angle AG2 of the first-type light-emitting element ED1 in the second display area DA2 (refer to FIG. 1) in the second direction DR2 may be about 45°.

The second transmissive portion TRP2 may be disposed between the vertical barrier walls VSW. The second transmissive portion TRP2 may be a transmissive portion disposed in the second display area DA2. The second transmissive portion TRP2 may be formed through a same process as the first-second transmissive portion TRP1-2. The height VSW-HT of the vertical barrier walls VSW may be smaller than the height HSW-HT of the horizontal barrier walls HSW.

The second transmissive portion TRP2 may include a transparent organic material. The light provided from the display panel DP may transmit through the second transmissive portion TRP2.

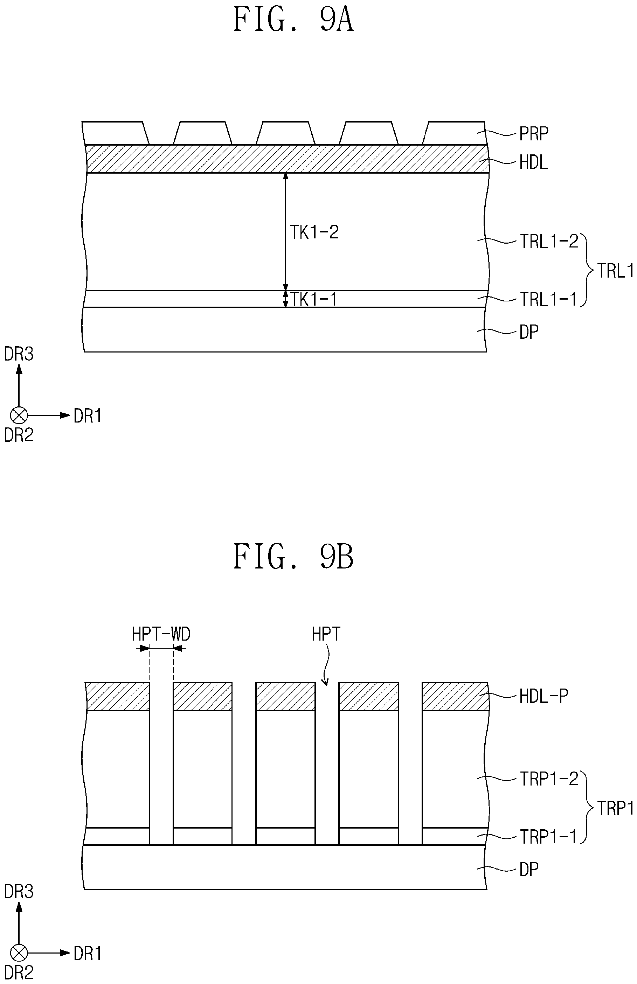

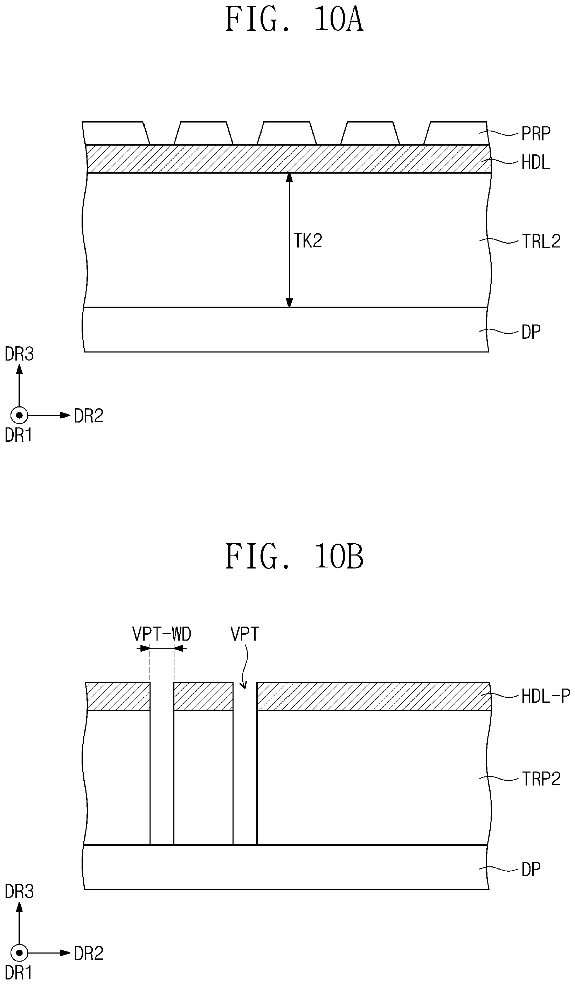

Referring to FIG. 8B, the second optical path control layer OSL2 may further include an organic layer TRL disposed on the display panel DP and an inorganic layer INL3 disposed on the organic layer TRL. The organic layer TRL of FIG. 8B may include the same material as and may be formed through a same process as the first-first transmissive portion TRP1-1 of FIG. 6. That is, different from that a first first transmissive layer TRL1-1 (refer to FIG. 9A) in the second display area DA2 is removed in a manufacturing method of the display device in the second display area DA2 described later, the first first transmissive layer TRL1-1 in the second display area DA2 may not be removed. In an embodiment where the first first transmissive layer TRL1-1 disposed in the second display area DA2 is not removed, the first first transmissive layer TRL1-1 may be defined as the organic layer TRL as shown in FIG. 8B. In addition, the inorganic layer INL3 may be disposed on the organic layer TRL to effectively prevent the organic layer TRL from being removed in a process of forming a vertical pattern VPT (refer to FIG. 10B). The inorganic layer INL3 may be referred to as a third inorganic layer. The vertical barrier walls VSW may be disposed on the third inorganic layer INL3.

FIGS. 9A to 11B are cross-sectional views illustrating a method of manufacturing the display device DD (refer to FIG. 1) according to an embodiment of the disclosure.

FIGS. 9A to 9D are cross-sectional views illustrating respective processes of an embodiment of the manufacturing method of the display device DD (refer to FIG. 1) in the first display area DA1 (refer to FIG. 1).

Referring to FIG. 9A, an embodiment of the manufacturing method of the display device may include preparing the display panel DP, forming a first transmissive layer TRL1 on the display panel DP, and forming a hard mask layer HDL and a photoresist pattern PRP on the first transmissive layer TRL1.

In the preparing of the display panel DP, the features of the display panel DP described above may be applied to the display panel DP shown in FIGS. 9A to 9D.

The forming of the first transmissive layer TRL1 on the display panel DP may include forming the first first transmissive layer TRL1-1 and forming a first second transmissive layer TRL1-2. The first first transmissive layer TRL1-1 and the first second transmissive layer TRL1-2 may be formed by coating and curing a transparent organic material.

The first first transmissive layer TRL1-1 may be formed by a slit coating method. The first first transmissive layer TRL1-1 may be formed to have a first-first thickness TK1-1. The first first thickness TK1-1 may be equal to or greater than about 3 µm and equal to or smaller than about 7 µm. In an embodiment, for example, the first-first thickness TK1-1 may be about 5 µm.

The first second transmissive layer TRL1-2 may be formed by an inkjet coating method. The first second transmissive layer TRL1-2 may be formed to have a second first thickness TK1-2. The second first thickness TK1-2 may be equal to or greater than about 30 µm and equal to or smaller than about 40 µm. In an embodiment, for example, the second first thickness TK1-2 may be about 35µm.

In the forming of the hard mask layer HDL and the photoresist pattern PRP on the first transmissive layer TRL1, the photoresist pattern PRP may be used to form the horizontal barrier walls HSW (refer to FIG. 5). Accordingly, the photoresist pattern PRP may be provided with openings arranged in the first direction DR1 and each extending in the second direction DR2.

Referring to FIG. 9B, an embodiment of the manufacturing method of the display device may include forming a horizontal pattern HPT on the first transmissive layer TRL1 (refer to FIG. 9A). The horizontal pattern HPT arranged in the first direction DR1 and each extending in the second direction DR2 may be formed through an exposure process and a development process using the photoresist pattern PRP. The horizontal pattern HPT may have a width HPT-WD equal to or greater than about 3 µm and equal to or smaller than about 5 µm. After the horizontal pattern HPT is formed, a hard mask pattern layer HDL-P may be removed. As the horizontal pattern HPT is formed, the first transmissive portion TRP1 may be formed.

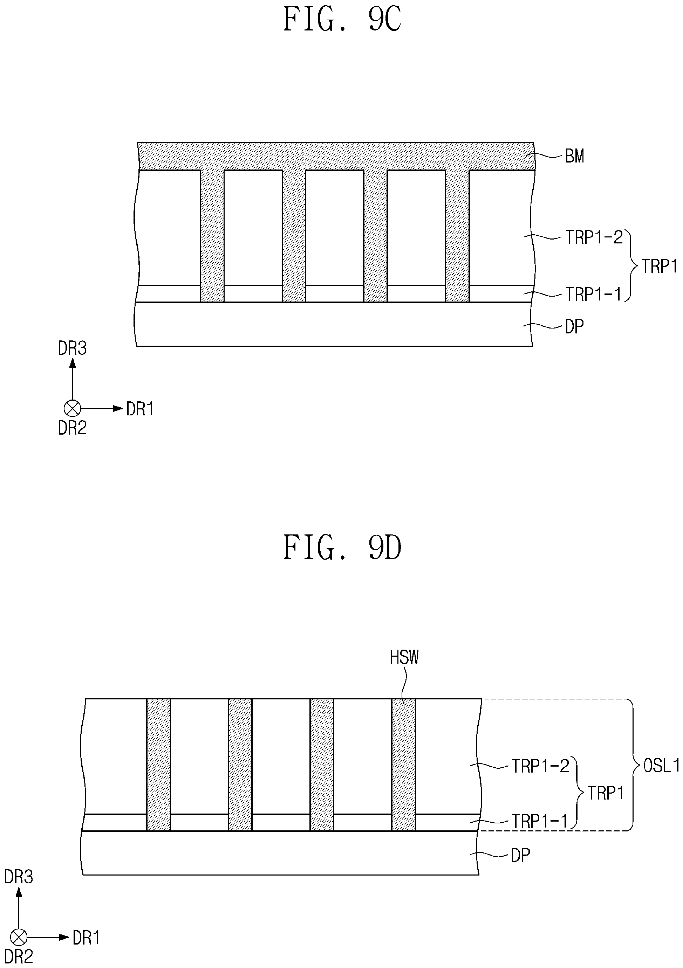

Referring to FIG. 9C, an embodiment of the manufacturing method of the display device may include coating a light blocking material BM on the horizontal pattern HPT (refer to FIG. 9B). The light blocking material BM may be filled in the horizontal pattern HPT (refer to FIG. 9B) defined in the first transmissive portion TRP1. The features of the material of the horizontal barrier walls HSW described above may be applied to the light blocking material BM.

Referring to FIG. 9D, an embodiment of the manufacturing method of the display device may include removing the light blocking material BM coated on the first transmissive portion TRP1. The light blocking material BM may be removed by a chemical mechanical polishing process, and thus, an upper surface of the first optical path control layer OSL1 may be flat. In addition, the horizontal barrier walls HSW arranged in the first direction DR1 and each extending in the second direction DR2 may be formed between the first transmissive portions TRP1. The features of the horizontal barrier walls HSW described above may be applied to the horizontal barrier walls HSW.

FIGS. 10A to 10D are cross-sectional views illustrating respective processes of the manufacturing method of the display device DD (refer to FIG. 1) in the second display area DA2 (refer to FIG. 1).

Referring to FIG. 10A, an embodiment of the manufacturing method of the display device may include preparing the display panel DP, forming a second transmissive layer TRL2 on the display panel DP, and forming the hard mask layer HDL and the photoresist pattern PRP on the second transmissive layer TRL2.

In the preparing of the display panel DP, the features of the display panel DP described above may be applied to the display panel DP of FIGS. 10A to 10D.

In an embodiment, as in the forming of the first first transmissive layer TRL1-1 described above with reference to FIG. 9A, the first first transmissive layer TRL1-1 is also formed in the second display area DA2. In another embodiment, the first first transmissive layer TRL1-1 formed in the second display area DA2 may be removed in a subsequent process.

The second transmissive layer TRL2 may be formed by coating and curing a transparent organic material. The second transmissive layer TRL2 may be formed through a same process as the first second transmissive layer TRL1-2. The second transmissive layer TRL2 may be formed through an inkjet coating method. The second transmissive layer TRL2 may be formed to have a second thickness TK2. The second thickness TK2 may be equal to or greater than about 20 µm and equal to or smaller than about 30 µm. In an embodiment, for example, the second thickness TK2 may be about 25 µm.

In the forming of the hard mask layer HDL and the photoresist pattern PRP on the transmissive layer TRL2, the photoresist pattern PRP may be used to form the vertical barrier walls VSW (refer to FIG. 7). Accordingly, the photoresist pattern PRP may be provided with openings defined therethrough, arranged in the second direction DR2, and each extending in the first direction DR1.

Referring to FIG. 10B, an embodiment of the manufacturing method of the display device may include forming the vertical pattern VPT in the second transmissive layer TRL2 (refer to FIG. 10A). The vertical pattern VPT arranged in the second direction DR2 and extending in the first direction DR1 may be formed through an exposure process and a development process using the photoresist pattern PRP. The vertical pattern VPT may have a width VPT-WD equal to or greater than about 3 µm and equal to or smaller than about 5 µm. The hard mask pattern layer HDL-P may be removed after the vertical pattern VPT is formed. As the vertical pattern VPT is formed, the second transmissive portion TRP2 may be formed.

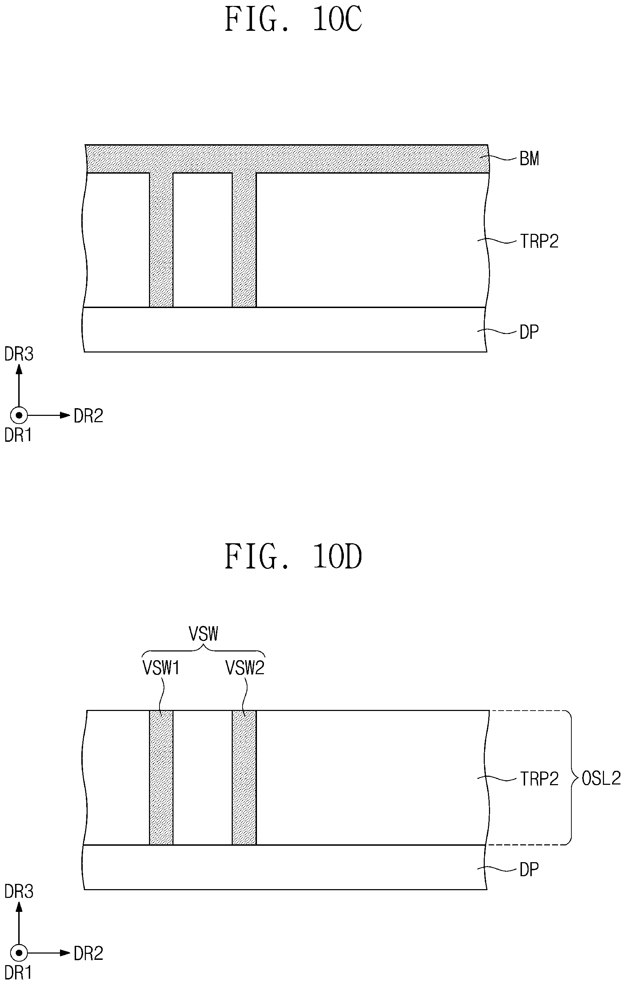

Referring to FIG. 10C, an embodiment of the manufacturing method of the display device may include coating the light blocking material BM on the vertical pattern VPT (refer to FIG. 10B). The light blocking material BM may be filled in the vertical pattern VPT (refer to FIG. 10B) defined through the second transmissive portion TRP2. The features of the light blocking material BM in FIG. 9C may be equally applied to the light blocking material BM in FIG. 10C.

Referring to FIG. 10D, an embodiment of the manufacturing method of the display device may include removing the light blocking material BM coated on the second transmissive portion TRP2. The light blocking material BM may be removed by the chemical mechanical polishing process, and an upper surface of the second optical path control layer OSL2 coated on the second transmissive portion TRP2 may be flat. In addition, the vertical barrier walls VSW arranged in the second direction DR2 and each extending in the first direction DR1 may be formed between the second transmissive portions TRP2. The previous descriptions on the vertical barrier walls VSW may be equally applied to the vertical barrier walls VSW in FIG. 10D.

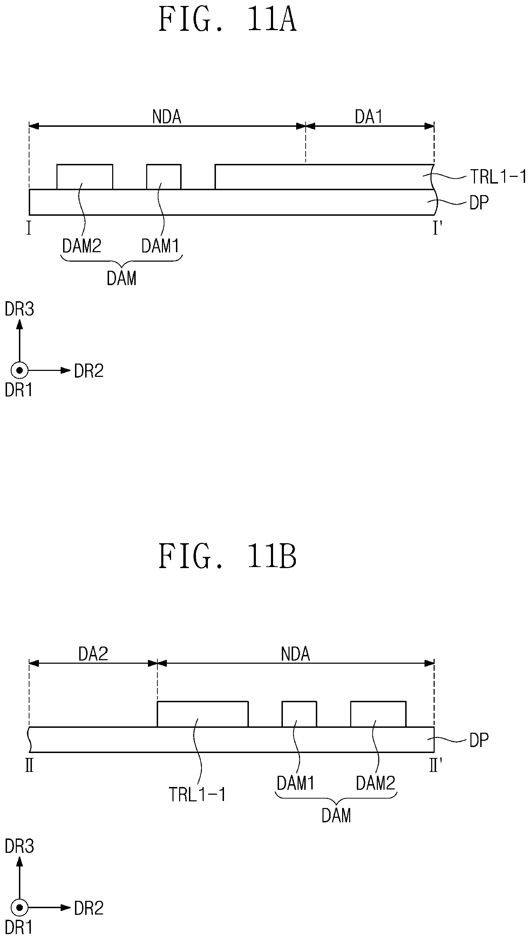

FIG. 11A is a cross-sectional view illustrating a manufacturing method of the display device DD (refer to FIG. 1) taken along line I-I' of FIG. 2A. FIG. 11B is a cross-sectional view illustrating a manufacturing method of the display device DD (refer to FIG. 1) taken along line II-II' of FIG. 2A.

FIG. 11A illustrates the first display area DA1 and the non-display area NDA adjacent to the first display area DA1. A dam DAM may be formed in the forming of the first-first transmissive layer TRL1-1 described with reference to FIG. 9A. The first first transmissive layer TRL1-1 may be formed in the first display area DA1 and a portion of the non-display area NDA, which is adjacent to the first display area DA1. The dam DAM may be formed in the non-display area NDA, and the dam DAM may include a first dam DAM1 adjacent to the display area DA (refer to FIG. 2A) and a second dam DAM2 spaced apart from the first display area DA1 with the first dam DAM1 interposed therebetween. Then, in the forming of the first second transmissive layer TRL1-2 described with reference to FIG. 9A, an inkjet coating material may only be coated up to the first-first transmissive layer TRL1-1 and may not overflow to the outside of the dam DAM.

FIG. 11B illustrates the second display area DA2 and the non-display area NDA adjacent to the second display area DA2. The dam DAM may be formed in the forming of the first first transmissive layer TRL1-1 described with reference to FIG. 9A. In the removing of the first first transmissive layer TRL1-1 from the second display area DA2, portions of the first first transmissive layer TRL1-1 may remain in the non-display area NDA, and the first dam DAM1 and the second dam DAM2 may be formed as shown in FIG. 11B.

Then, in the forming of the second transmissive layer TRL2 described with reference to FIG. 10A, the inkjet coating material may only be coated up to the first-first transmissive layer TRL1-1 of FIG. 11B and may not overflow to the outside of the dam DAM.

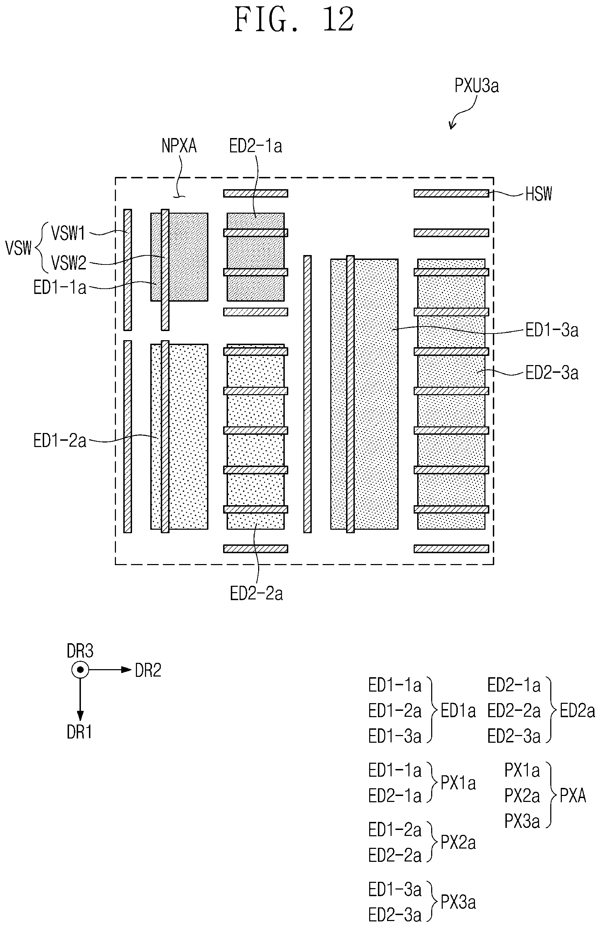

FIG. 12 is an enlarged plan view illustrating display areas DA1 and DA2 (refer to FIG. 1) according to an embodiment of the disclosure.

FIG. 12 illustrates an embodiment of a pixel unit PXU3a disposed in a first display area (refer to DA1 of FIG. 1) and a second display area (refer to DA2 of FIG. 1). The pixel unit PXU3a may be disposed in each of the first display area DA1 (refer to FIG. 1) and the second display area DA2 (refer to FIG. 1). One pixel unit PXU3a may include a first color pixel PX1a, a second color pixel PX2a, and a third color pixel PX3a. The first color pixel PX1a may emit a first color light, e.g., a red light. The second color pixel PX2a may emit a second color light, e.g., a green light. The third color pixel PX3a may emit a third color light, e.g., a blue light.

The second color pixel PX2a may be disposed spaced apart from the first color pixel PX1a in the first direction DR1. The third color pixel PX3a may be disposed spaced apart from the first color pixel PX1a and the second color pixel PX2a in the second direction DR2. Each of the first, second, and third color pixels PX1a, PX2a, and PX3a may have a rectangular shape in the plan view. In an embodiment, the first color pixel PX1a may have the smallest size, and the third color pixel PX3a may have the largest size.

However, the arrangement, shape, and size of the first, second, and third color pixels PX1a, PX2a, and PX3a should not be limited thereto or thereby. The arrangement, shape, and size of the first, second, and third color pixels PX1a, PX2a, and PX3a may be variously modified if desired.

In an embodiment, the pixel unit PXU3a may include a first-type light-emitting element ED1a and a second-type light-emitting element ED2a. In each of the first, second, and third color pixels PX1a, PX2a, and PX3a, the light emitting element included in the first-type light-emitting element ED1a may be disposed in a left side, and the light emitting element included in the second-type light-emitting element ED2a may be disposed at a right side with respect to the second direction DR2. The first-type light-emitting element ED1a and the second-type light-emitting element ED2a may be disposed spaced apart from each other in the second direction DR2.

An embodiment of the display device DD including the pixel unit PXU3a shown in FIG. 12 may include an optical path control layer (refer to OSL1 of FIG. 6) in an area where the second-type light-emitting element ED2a is disposed and may include an optical path control layer (refer to OSL2 of FIGS. 8A or 8B) in an area where the first-type light-emitting element ED1a is disposed.

In such an embodiment, a viewing angle (refer to AG1 of FIG. 6) of a light emitted from the second-type light-emitting element ED2a may be limited by a plurality of horizontal barrier walls HSW in the first direction DR1. In such an embodiment, a viewing angle AG2 of a light emitted from the first-type light-emitting element ED1a may be limited by a plurality of vertical barrier walls VSW in the second direction DR2.

The first-type light-emitting element ED1a and the second-type light-emitting element ED2a may operate differently or independently of each other. In an embodiment, both the first-type light-emitting element ED1a and the second-type light-emitting element ED2a may operate, or only one of the first-type light-emitting element ED1a and the second-type light-emitting element ED2a may operate. In an embodiment, for example, in a first mode, the first-type light-emitting element ED1a may not operate, and only the second-type light-emitting element ED2a may operate, and in a second mode, only the first-type light-emitting element ED1a may operate, and the second-type light-emitting element ED2a may not operate. When only the second-type light-emitting element ED2a operates, only the viewing angle in the first direction DR1 may be limited, and the viewing angle in the second direction DR2 may not be limited. When only the first-type light-emitting element ED1a operates, the viewing angle in the second direction DR2 may be limited.

In the first display area DA1 and the second display area DA2, the first-type light-emitting element ED1a and the second-type light-emitting element ED2a may operate differently. In an embodiment, for example, in the first mode and the second mode of the first display area DA1, both the first-type light-emitting element ED1a and the second-type light-emitting element ED2a may operate, only the first-type light-emitting element ED1a may operate, or only the second-type light-emitting element ED2a may operate. In the first mode of the second display area DA2, both the first-type light-emitting element ED1a and the second-type light-emitting element ED2a may operate or only the second-type light-emitting element ED2a may operate, and thus, images displayed through the second display area DA2 may be perceived from the driver's seat as shown in FIG. 2A. In addition, in the second mode of the second display area DA2, only the first-type light-emitting element ED1a may operate, and thus, images displayed through the second display area DA2 may not be perceived from the driver's seat as shown in FIG. 2B. However, the operations of the first and second-type light-emitting elements ED1a and ED2a in the first and second display areas DA1 and DA2 should not be limited thereto or thereby and may be modified to operate differently if desired.

The first-type light-emitting element ED1a may include a first first-type light-emitting element ED1-1a disposed in the first color pixel PX1a, a second first-type light-emitting element ED1-2a disposed in the second color pixel PX2a, and a third first-type light-emitting element ED1-3a disposed in the third color pixel PX3a. The second-type light-emitting element ED2a may include a first second-type light-emitting element ED2-1a disposed in the first color pixel PX1a, a second second-type light-emitting element ED2-2a disposed in the second color pixel PX2a, and a third second-type light-emitting element ED2-3a disposed in the third color pixel PX3a.

The first second-type light emitting element ED2-1a may be disposed spaced apart from the first first-type light emitting element ED1-1a in the second direction DR2. The second second-type light-emitting element ED2-2a may be disposed spaced apart from the second first-type light-emitting element ED1-2a in the second direction DR2. The third second-type light-emitting element ED2-3a may be disposed spaced apart from the third first-type light-emitting element ED1-3a in the second direction DR2.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. An electronic device comprising a display device, the display device comprising a display area comprising a first display area and a second display area adjacent to the first display area and a non-display area surrounding the display area,
wherein the display device comprises:
a display panel comprising a circuit layer comprising a pixel driving circuit and a light emitting element layer disposed on the circuit layer, wherein the display panel comprises a light emitting area and a non-light-emitting area surrounding the light emitting area; and
an optical path control layer disposed on the display panel to control an optical path of a light provided thereto from the display panel,
wherein the optical path control layer in the first display area comprises a plurality of horizontal barrier walls arranged in a first direction and each extending in a second direction,
the optical path control layer in the second display area comprises a plurality of vertical barrier walls arranged in the second direction and each extending in the first direction,
the first direction is perpendicular to a plane defined by a direction toward the second display area from the first display area and a direction toward the optical path control layer from the display panel,
the second direction is substantially parallel to the direction toward the second display area from the first display area, and
a transmissive portion is disposed between the horizontal barrier walls and between the vertical barrier walls.

2. The electronic device of claim 1, wherein each of the horizontal barrier walls and each of the vertical barrier walls comprise a light blocking material or a light absorbing material.

3. The electronic device of claim 1 or claim 2, wherein the light emitting element layer comprises:
a first-type light-emitting element electrically connected to the pixel driving circuit; and
a second-type light-emitting element electrically connected to the pixel driving circuit and disposed spaced apart from the first-type light-emitting element in the second direction.

4. The electronic device of claim 3, wherein a color of a light emitted from the first-type light-emitting element is substantially the same as a color of a light emitted from the second-type light-emitting element.

5. The electronic device of claim 3 or claim 4, wherein each of the first-type light-emitting element and each of the second-type light-emitting element overlaps the horizontal barrier walls in a plan view.

6. The electronic device of any one of claims 3 to 5, wherein the first-type light-emitting element overlaps the vertical barrier walls in a plan view, and
the second-type light-emitting element does not overlap the vertical barrier walls in the plan view.

7. The electronic device of any one of claims 3 to 6, wherein the light emitting element layer comprises a pixel definition layer which defines the light emitting area, and
the vertical barrier walls comprise:
a plurality of first vertical barrier walls overlapping the pixel definition layer in a plan view; and
a plurality of second vertical barrier walls overlapping the first-type light-emitting element in the plan view.

8. The electronic device of any one of claims 3 to 7, wherein the pixel driving circuit is configured to selectively operate in one of a first mode and a second mode,
the first-type light-emitting element does not emit a light in the first mode, the second-type light-emitting element emits a light in the first mode,
the first-type light-emitting element emits the light in the second mode, and the second-type light-emitting element does not emit the light in the second mode.

9. The electronic device of any one of claims 3 to 8, wherein the first-type light-emitting element comprises a first first-type light-emitting element which emits a first color light, a second first-type light-emitting element which emits a second color light different from the first color light, and a third first-type light-emitting element which emits a third color light different from each of the first and second color lights,
the second first-type light-emitting element is disposed spaced apart from the first first-type light-emitting element in the first direction, and
the third first-type light-emitting element is disposed spaced apart from the first first-type light-emitting element in the second direction.

10. The electronic device of claim 9, wherein the second-type light-emitting element comprises a first second-type light-emitting element which emits a light having substantially a same color as the first first-type light-emitting element, a second second-type light-emitting element which emits a light having substantially a same color as the second first-type light-emitting element, and a third second-type light-emitting element which emits a light having substantially a same color as the third first-type light-emitting element,
the first second-type light-emitting element is disposed spaced apart from the first first-type light-emitting element in the second direction,
the second second-type light-emitting element is disposed spaced apart from the second first-type light-emitting element in the second direction, and
the third second-type light-emitting element is disposed spaced apart from the third first-type light-emitting element in the second direction.

11. A method of manufacturing a display device, the method comprising:
preparing a display panel comprising a display area comprising a first display area and a second display area adjacent to the first display area and a non-display area surrounding the display area;
forming an organic pattern layer on the display panel;
forming a transparent layer on the display panel through an inkjet coating process; and
forming a light blocking pattern on the transparent layer and the organic pattern layer,
wherein the forming the transparent layer comprises:
forming a first transparent layer on the display panel in the first display area; and
forming a second transparent layer on the display panel in the second display area,
wherein the forming the light blocking pattern comprises:
forming a horizontal light blocking pattern arranged in a first direction and each extending in a second direction in the first display area; and
forming a vertical light blocking pattern arranged in the second direction and each extending in the first direction in the second display area,
wherein the first direction is perpendicular to a plane defined by a direction toward the second display area from the first display area and a direction toward the transparent layer from the display panel, and
the second direction is substantially parallel to the direction toward the second display area from the first display area.

12. The method of claim 11, wherein the forming the light blocking pattern comprises:
forming a horizontal pattern arranged in the first direction and each extending in the second direction and a vertical pattern arranged in the second direction and each extending in the first direction in the transparent layer and the organic pattern layer through a photoresist process; and
providing a light absorbing material in the horizontal pattern and the vertical pattern to form a plurality of barrier walls.

13. The method of claim 11 or claim 12, wherein the display panel comprises:
a first-type light-emitting element; and
a second-type light-emitting element disposed spaced apart from the first-type light-emitting element in the second direction,
in the forming the light blocking pattern,
the horizontal light blocking pattern is formed to overlap each of the first-type light-emitting element and each of the second-type light-emitting element in a plan view, and
the vertical light blocking pattern is formed to overlap the first-type light-emitting element and not to overlap the second-type light-emitting element in the plan view.

14. The method of any one of claims 11 to 13, wherein the forming the organic pattern layer comprises:
forming an organic layer on the display panel; and
patterning the organic layer through a photoresist process to form a dam in a way such that the organic layer remains in the first display area, the organic layer is removed in the second display area, and the organic layer remains in a portion of the non-display area.
